# EUROPÄISCHE PATENTSCHRIFT

(11) **EP 0 417 642 B1**
(45) Veröffentlichungstag und Bekanntmachung des Hinweises auf die Patenterteilung: **09.04.1997**
(21) Anmeldenummer: 90117160.3
(22) Anmeldetag: 06.09.1990
(51) Int. Cl.: H01J 37/063

(54) **Elektronenstrahlerzeuger, insbesondere für eine Elektronenstrahlkanone**
Device for producing electron beams, particularly for an electron gun
Dispositif de production d'un faisceau d'électrons, en particulier pour canon à électrons

(30) Priorität: 09.09.1989 DE 3930199
(43) Veröffentlichungstag der Anmeldung: 20.03.1991
(73) Patentinhaber: PTR PRÄZISIONSTECHNIK GMBH, 63461 Maintal (DE)
(72) Erfinder: Fritz, Dieter, D-6460 Gelnhausen (DE)
(74) Vertreter: Sartorius, Peter, Dipl.-Ing.

(56) Entgegenhaltungen:
- EP-A- 0 117 475
- GB-A- 1 180 013
- US-A- 3 825 327
- S. Schiller, U. Heisig, S. Panzer: Electron Beam Technology. New York 1982. Seiten 56-63.

## Beschreibung

Die Erfindung betrifft einen Elektronenstrahlerzeuger, insbesondere für eine Elektronenstrahlkanone, mit einer Kathode, einer Steuerelektrode und einer Anode.

Elektronenstrahlerzeuger der angegebenen Art sind allgemein bekannt. Sie sind üblicherweise so ausgebildet, daß der Elektronenstrahl aus der Emissionsfläche der Kathode austritt und einen Fokussierpunkt oder Cross-over bildet, der von einer nachfolgenden Elektronenoptik, beispielsweise einer Magnetlinse, abgebildet wird. Dient der Elektronenstrahl in einer Elektronenstrahlkanone zur Bearbeitung eines Werkstücks, so wird durch die Wahl eines geeigneten Abbildungsverhältnisses eine möglichst scharf gebündelte Abbildung des Crossovers auf dem Werkstück angestrebt, um dort eine möglichst hohe Energiedichte zu erzielen. Mit zunehmendem Strahlstrom verlagert sich jedoch der Cross-over in Strahlrichtung. Dadurch wird der Strahlwinkel kleiner, wobei die Raumladungsaufspreizung zunimmt. Die Gegenstandsweite der elektronenoptischen Abbildung wird kleiner, und das Abbildungsverhältnis verschlechtert sich. Damit läßt sich am Werkstück keine ausreichende Fokussierung des Elektronenstrahls mehr erzielen.

Es ist bereits bekannt (S. Schiller, U. Heisig, S. Panzer: Electron Beam Technology), eine Zwei-Elektronenstrahl-Kanone mit der Kathode K, der Anode A, der Fokus-Elektrode F und dem reellen Cross-over C zu versehen.

Die britische Patentschrift 1 180 013 zeigt dagegen lediglich zwischen Anode und Kathode eine Anordnung von mehreren Röhrchen, die die Aufgabe haben, die Elektronen auszurichten, die mit thermischer Emission emittieren. Die hierzu erforderliche Anfangsgeschwindigkeit wird durch entsprechenden Temperaturanstieg bewirkt.

Die US-Patentschrift 3 835 327 zeigt bereits einen Elektronenstrahlerzeuger mit einer in einem Gehäuse aufgenommenen Kathode, der eine Anode mit zentraler Bohrung nachgeordnet ist. An die Anode schließt sich eine mit einer Bohrung versehene Blende an. Der Elektronenstrahl wird über eine Sammellinse umgelenkt und auf ein Arbeitswerkstück geleitet. Bei dieser Anordnung wird mit einem negativ gesteuerten Wehnelt-Zylinder und mit konstantem Fokus gearbeitet. Der Elektronenstrahl wird gebündelt und dadurch ebenfalls ein reeller Cross-over erzeugt, der von der Magnetlinse abgebildet wird. Mit steigendem Strahlstrom verlagert sich jedoch der Cross-over bei der bekannten Anordnung nach unten, und die Gegenstandsweite wird somit kleiner. Den Elektronenstrahl auch bei hohem Strahlstrom bzw. großer Leistungsdichte gut abzubilden und fokussieren, kann mit der bekannten Anordnung nicht erreicht werden.

Demgegenüber liegt der Erfindung die Aufgabe zugrunde, einen Elektronenstrahlerzeuger der eingangs aufgeführten Art zu schaffen, dessen Elektronenstrahl auch bei hohem Strahlstrom bzw. großer Leistungsdichte gut abgebildet und fokussiert werden kann.

Erfindungsgemäß wird diese Aufgabe durch die Merkmale von Anspruch 1.

Bei einem derartigen Elektronenstrahl erzeuger wird von der Elektronenoptik, beispielsweise der Magnetlinse ein virtueller Crossover abgebildet, wodurch ein optimales Abbildungsverhältnis mit großer Gegenstandsweite und kleinem Brennfleck am Werkstück erreicht wird. Die Raumladungsaufspreizung wird nahezu eliminiert. Der Raumladungseffekt ist im wesentlichen nur noch am Werkstück wirksam, wo er gut kompensiert ist.

Die divergierende Strahlform wird durch die Formgestalt und die Dimensionierung der Steuerelektrode und der Anode erreicht. Hierbei ist es vorteilhaft, wenn zur Erzeugung des divergierenden Strahlenbündels der bekannte Anodenlinseneffekt ausgenutzt wird.

Es ist zwar bekannt, daß bei Elektronenstrahlerzeugern kleiner Leistung sich in der Regel durch den gekrümmten Bahnverlauf der Elektronen im Bereich des reellen Crossover auch die Eigenschaften eines virtuellen Crossover ergeben. Bei Elektronenstrahlerzeugern hoher Perveanz ist dieser Effekt jedoch nicht vorhanden.

Die Erfindung wird nachfolgend anhand einer Schemazeichnung näher erläutert. Es zeigen
- Fig. 1: den Elektronenstrahl bei einem bekannten Strahlerzeuger und
- Fig. 2: den Elektronenstrahl bei einem erfindungsgemäßen Strahlerzeuger.

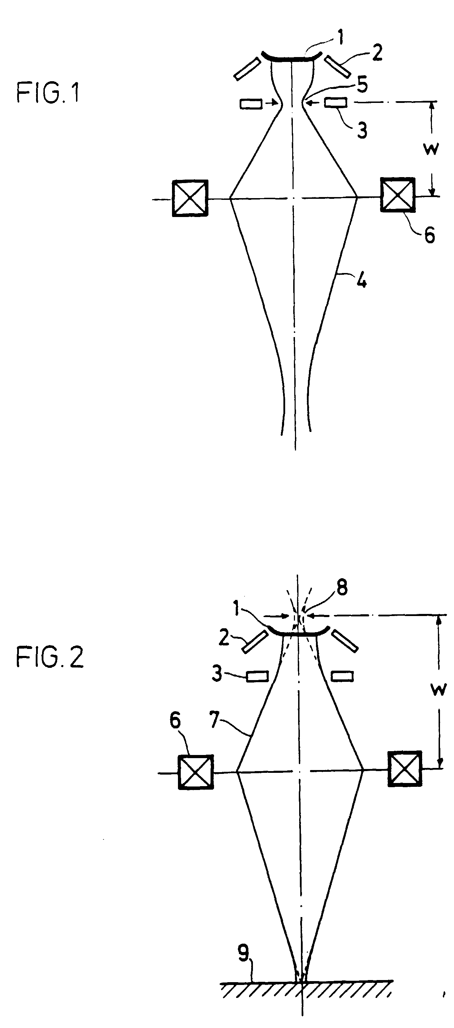

In beiden Figuren ist im Schnitt eine Katode 1, eine Steuerelektrode 2 und der mittlere Bereich einer Anode 3 dargestellt. Bei dem bekannten Elektronenstrahlerzeuger gemäß Fig. 1 wird der Elektronenstrahl 4 zunächst gebündelt und bildet dadurch einen reellen Crossover 5, der von der Magnetlinse 6 abgebildet wird. Mit steigendem Strahlstrom verlagert sich der Crossover 5 nach unten und die Gegenstandsweite w wird kleiner.

Bei dem Strahlerzeuger gemäß Fig. 2 wird durch das Potential und die Form der Steuerelektrode 2 und der Anode 3 zwischen beiden ein elektrostatisches Feld erzeugt, durch das die aus der Katode 1 austretenden Elektronen in Form eines divergierenden Elektronenstrahls 7 mit vergleichsweise großem Durchmesser die Anode 3 verlassen. Der divergierende Elektronenstrahl 7 hat bei seinem Eintritt in die Magnetlinse 6 die Eigenschaften eines Strahlenbündels, welches von einem durch die Spitze des nach hinten verlängerten Strahlenkegels gebildeten, virtuellen Crossover 8 ausgeht. Von der Magnetlinse 6 wird daher der Elektronenstrahl 7 mit seinem virtuellen Crossover 8 auf die Oberfläche eines Werkstücks 9 projiziert, wodurch dort ein kleiner Brennfleck mit einer hohen Strahldichte erzielt wird. Wie die Darstellung zeigt, ergibt sich durch die Lage des virtuellen Crossover 8 eine große Gegenstandsweite w und damit ein optimales Abbildungsverhältnis.

## Patentansprüche

1. Elektronenstrahlkanone mit einer Kathode (1) und einer Steuerelektrode (2), die die Kathode (1) umgibt, einer eine zentrale Bohrung aufweisenden, nachgeschalteten Anode (3) für den Durchtritt des Elektronenstrahls (7), sowie einer elektronenoptischen Einrichtung, insbesondere einer Magnetlinse, zur fokussierung des Elektronenstrahls auf ein Werkstück, **dadurch gekennzeichnet, daß** an die Steuerelektrode (2) und die Anode (3) ein Potential angelegt ist, wobei die aus der Kathode (1) austretenden Elektronen in Form eines divergierenden Elektronenstrahls (7) aus der Anode (3) heraustreten und ohne weitere Crossover in die elektronenoptische Einrichtung eintreten, und **daß** der divergierende Elektronenstrahl (7) von der elektronenoptischen Einrichtung ausgehend ohne Crossover auf die Bearbeitungsstelle eines Werkstücks projiziert wird.

## Claims

1. Electron beam gun with a cathode (1) and a control electrode (2) which surrounds the cathode (1), a subsequent anode (3) having a central bore for the passage of the electron beam (7), as well as an optoelectronic unit, especially a magnetic lens for focusing the electron beam onto a workpiece, **characterized in that** a potential is applied to the control electrode (2) and to the anode (3), whereby the electrons emanating from the cathode (1) emerge from the anode (3) in the form of a diverging electron beam (7) and enter the optoelectronic unit without further crossover, and **in that** the diverging electron beam (7) emerging from the optoelectronic unit is projected onto the working site of a workpiece without crossover.

## Revendications

1. Canon à électrons comportant une cathode (1), une électrode de commande (2) qui entoure la cathode (1), une anode (3) montée en aval et présentant un alésage central pour le passage du faisceau électronique (7), ainsi qu'un dispositif électrono-optique, notamment une lentille magnétique, pour la focalisation du faisceau électronique sur une pièce à usiner, **caractérisé en ce qu**'un potentiel est appliqué à l'électrode de commande (2) et à l'anode (3), les électrons émis de la cathode (1) quittant l'anode (3) sous forme d'un faisceau électronique divergent (7) et entrant dans le dispositif électrono-optique sans qu'il y ait d'autres crossovers, et en ce que le faisceau électronique (7) partant du dispositif électrono-optique est projeté sans crossover sur l'endroit à usiner d'une pièce.
